# EUROPEAN PATENT APPLICATION

(11) **EP 3 010 148 A1**
(43) Date of publication of application: **20.04.2016**
(21) Application number: 14189184.6
(22) Date of filing: 16.10.2014
(51) Int. Cl.: H03H 7/40

(54) **Automatic impedance adjustment**

(71) Applicant: NXP B.V., 5656 AG Eindhoven (NL)
(72) Inventor: Gebhart, Michael, 5656 AG Eindhoven (NL); Baier, Thomas, 5656 AG Eindhoven (NL)
(74) Representative: Hardingham, Christopher Mark

(57) **Abstract**

An apparatus and method are described for automatically matching the impedance of an antenna. An impedance matching network includes at least one variable impedance element and has an input for receiving a drive signal and an output connectable to an antenna. The impedance matching network includes a shunt capacitor in series between the input and output. A phase measuring measures the phase difference between the voltage and the current of the drive signal using the voltage drop across the shunt capacitor and outputs a measured phase signal. A voltage measuring circuit measures the magnitude of the voltage of the drive signal and the voltage drop across the shunt capacitor and outputs a measured drive voltage signal and shunt capacitor voltage signal. An automatic impedance matching circuit can output a control signal to adjust the impedance of the variable impedance element and determines the impedance of the impedance matching network from the measured phase, drive voltage and shunt capacitor voltages automatically to reduce the difference between the determined impedance of the impedance matching network and the impedance of the antenna.

## Description

The present invention relates to impedance adjustment and in particular to apparatus and methods for automatically adjusting the impedance of a network to a target impedance.

Impedance matching is known generally and relates to maximising the transfer of electrical power from a source of electrical power to an electrical load whose impedances may differ. For example, impedance matching may be provided between a power supply, for example including an RF amplifier, and a load, such as an antenna.

High power transfer efficiency aims to achieve almost 100% of the RF power being consumed by the load and almost 0% being dissipated by the source of electrical power, e.g. by the internal resistance of an RF amplifier. Hence, the source should have a low output impedance and the load should have a fixed input impedance whose value is optimum for consuming all the electrical power offered by the source. This can be achieved by reactance matching in which the imaginary part of the load input impedance and the source output impedance compensate each other, and the real part of the load input impedance has an optimum value which is higher compared to the real part of the source output resistance.

This kind of impedance adjustment can be particularly challenging for AC electrical systems as the impedance and/or behaviour of electrical components of the load may vary with the frequency of the electrical signals or under different operating conditions

One area in which impedance adjustment is used is in proximity readers as used in contactless communications systems, such as those defined by the Proximity, Vicinity and Near Field Communication (NFC) standards. For example NFC readers may use a narrow-band impedance adjustment network between an antenna and an integrated driver amplifier.

US 2013/0109305 and WO 2012/103222 describe a variety of approaches to automatically matching the impedance of an NFC antenna.

However, the antenna impedance is not fixed. For contactless communications technologies, the antenna impedance can vary depending on a number of factors, including, fabrication tolerances (especially ferrite foils, which are often used to operate NFC antennas on metal), the ambient temperature of the antenna, and the distance of an NFC tag to metal parts or to contactless cards in operation.

A mismatch of the impedance presented by the antenna network towards the NFC chip output, which contains an integrated amplifier, e.g. a change from 50 Ohms to 10 Ohms, would mean that five times more power would be required to achieve the same alternating H-field at the antenna.

Moreover, a significantly reactive load impedance can be more problematic for the amplifier, as it can result in increased emission of harmonics, which may be limited by frequency regulation of technical specifications or standards. In general, a shift in resonance frequency of the reader antenna network means a weaker H-field is emitted by the antenna, for the same input power into the antenna network. Moreover, this can cause modulation distortion violating the specification or standard and so also may cause communication problems.

The present invention relates to improving the efficiency of electrical power transmission by automatically adjusting the impedance of a network to which electrical power is to be supplied to a target impedance, and is particularly suitable for contactless power transmission and communication applications.

A first aspect of the invention provides an apparatus for automatically adjusting the impedance of network to match a target impedance, the apparatus comprising: an electrical power source configured to deliver AC electrical power to a target impedance; a network having an input for receiving a drive signal from the electrical power source and an output connectable to an antenna, the network including a shunt reactance between the input and the output and at least one variable impedance element; a phase measuring circuit arranged to measure the phase difference between the voltage of the drive signal and the current of the drive signal in the network using the voltage drop across the shunt reactance; a voltage measuring circuit arranged to measure the magnitude of the voltage of the drive signal and the magnitude of the voltage drop across the shunt reactance; and an automatic impedance adjustment circuit in communication with the variable impedance element, the phase measuring circuit and the voltage measuring circuit and arranged to receive the measured phase difference, measured magnitude of the voltage of the drive signal and measured magnitude of the voltage drop across the shunt reactance, to determine the impedance of the network from them and automatically to reduce the difference between the determined impedance of the network and the target impedance by outputting a control signal to adjust the impedance of the variable impedance element.

The use of the shunt reactance allows the impedance to be measured under the operating conditions of the network, such as frequency and power, which can be beneficial if there are frequency and power dependent components in the network.

The electrical power source may be configured to deliver AC electrical power with an optimal efficiency to the target impedance. The target impedance may be an entirely real impedance. The target impedance may be in the range of 10Ω to 50Ω, more particularly in the range of 20Ω to 40Ω, and most particularly in the range or 25Ω to 35Ω, for example 30Ω.

The network may include a plurality of variable impedance elements. The network may include a first variable impedance element and a second variable impedance element. The automatic impedance adjustment circuit may be arranged to output a first control signal to adjust the impedance of the first variable impedance element and a second control signal to adjust the impedance of the second variable impedance element independently of the first variable impedance element. Adjusting the first variable impedance element may make the impedance of the network entirely real by compensating for any imaginary part of the impedance of the network. Adjusting the second variable impedance element may change the magnitude of the impedance of the network so as to be closer to the magnitude of the target impedance. Also, independently adjusting the variable impedance elements allows smaller changes in the impedance of the network which may improve matching with the target impedance.

The first variable impedance element may be connected in series with the input and the output and/or the second variable impedance element may be connected in parallel with the input and the output.

The or each variable impedance element may be a capacitor or a capacitor network. The capacitor network may include electronically controllable switches which are operable to vary the impedance of the capacitor network. The capacitor network may be provided as an integrated circuit.

The shunt reactance may be a shunt capacitor. A shunt capacitor may provide no additional losses in the network.

The shunt reactance may be a shunt inductor. The network may include an EMC filter. When the shunt reactance is a shunt inductor, then the shunt inductor may also form part of the EMC filter. An EMC filter may be provided when the electrical power source generates a driving signal with a square wave form

The network may not include an EMC filter. No EMC filter may be provided in the network when the electrical power source generates a sinusoidal driving signal. The shunt reactance may be a shunt capacitor which provides no extra losses or a shunt inductor, which although providing greater losses may provide some filtering.

The automatic impedance adjustment circuit may implement an algorithm to reduce the difference between the impedance of the network and the target impedance. The algorithm may be an iterative algorithm. The algorithm may minimise the difference between the impedance of the network and the target impedance. The algorithm may be based on or use Newton's method. This provides a computationally practicable algorithm for determining approximate solutions and hence practicable impedance adjustment without using exact solutions.

The algorithm may adjusts the impedance of a first variable impedance element and a second variable impedance element in turn on alternate iterations. This allows smaller changes in impedance to be made and so may provide better impedance matches. Also, this may allow the impedance of the network to be made real by compensating for any imaginary parts of the impedance of the network as well as allowing adjustment of the magnitude of the impedance of the network.

The iterative algorithm may use an approximation of a Jacobi matrix. This allows approximate solutions to be found in the absence of a differentiable function. The elements of the approximation of the Jacobi matrix may include quotients of the differences between a current and a preceding value of the reactance of the network and the capacitance of the variable impedance element and/or the differences between a current and a preceding value of the resistance of the network and the capacitance of the variable impedance element.

A second aspect of the invention provides a semiconductor package comprising a lead frame and an integrated circuit, wherein the integrated circuit comprises the apparatus of any preceding claim.

A third aspect of the invention provides a device including the package of the second aspect of the invention and an antenna connected to the output of the network. The device may be configured to operate in a reader mode, a card emulation mode or a peer-to-peer mode. The device may be an NFC device, a Proximity device or a FeliCa device.

A fourth aspect of the invention provides a method for automatically adjusting the impedance of a network to match a target impedance, the method comprising: determining the phase difference between the voltage of an AC drive signal applied to an input of a network and the current of the AC drive signal using the voltage drop across a shunt reactance connected in series between an input of the network and an antenna; determining a first peak magnitude of the voltage of the drive signal and a second peak magnitude of the voltage drop across the shunt reactance; and iteratively reducing the difference between the impedance of the network, determined using the phase difference and the first and second peak magnitudes, and a target impedance by adjusting the impedance of a variable impedance element in the network.

An algorithm based on Newton's method may be used to iteratively minimise the difference between the impedance of the network and the target impedance.

Iteratively reducing the difference may further include varying the impedance of a first variable impedance element connected in series in the network and varying the impedance of a second variable impedance element connected in parallel in the network in turn on alternate iterations.

Other preferred features of the method may correspond to counterpart features of the preferred features of the first aspect of the invention.

Embodiments of the invention will now be described, by way of example only, and with reference to the accompanying drawings, in which:
Figure 1 shows a schematic block diagram of an electrical system and an impedance adjustment apparatus according to the invention;
Figures 2A to 2D respectively show first to fourth embodiments of a voltage measuring part of the load network of the impedance adjustment apparatus of Figure 1;
Figure 3 shows a schematic block diagram showing phase measurement and voltage measurement circuitry parts of impedance adjustment apparatus;
Figure 4 shows a schematic block diagram of a variable capacitance network used in the impedance adjustment apparatus of Figure 1; and
Figure 5 shows a flow chart illustrating an automatic impedance matching method according to the invention and implemented by impedance adjustment apparatus of Figure 1.

An embodiment of the invention will now be described within the context of near field communication (NFC). However, it will be appreciated that the invention is not necessarily limited to that specific application. Rather, the principles of the invention can be applied to other wireless or contactless electrical systems which utilise an antenna and in which improving the transfer of electrical power between the source and the antenna may be beneficial.

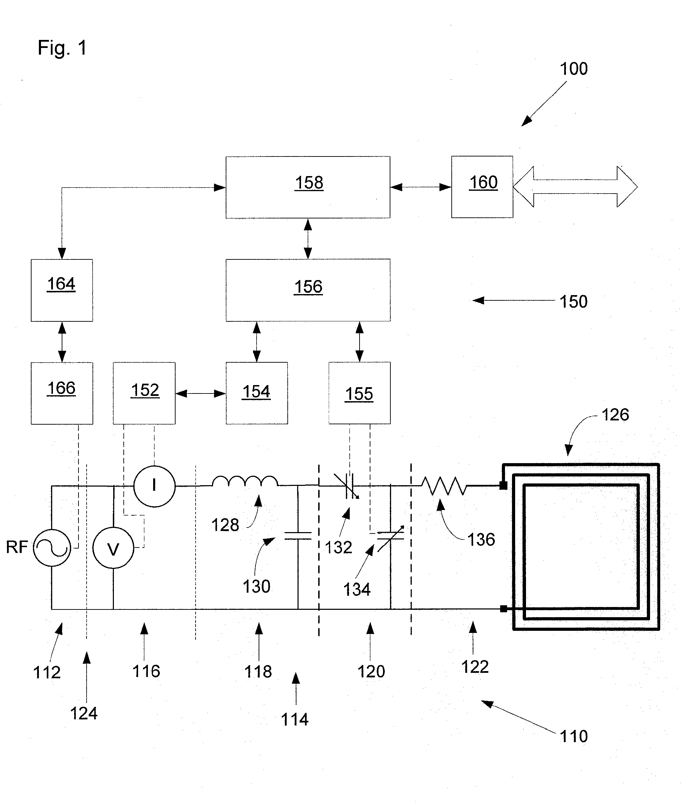

With reference to Figure 1, there is shown a schematic block diagram of a wireless or contactless electrical system 100 including impedance matching apparatus according to the invention and which operates according to a method of the invention. The system generally includes an analogue portion 110 and a digital portion 150.

The analogue portion 110 includes a source of RF electrical power 112 which includes an amplifier. The analogue portion also includes a network 114 attached to the output of the power source 112 and which includes a number of stages. Some of the stages of the network 114 are optional and may not be present, or may vary, in other embodiments. Network 114 includes a measurement stage 116, optionally an EMC filter stage 118, an adjustable impedance stage 120 and an antenna stage 122.

The output impedance of the power source 112 and the impedance that the power source 112 expects to see can be set before hand for optimal power transfer. For example, the power source 112 can be configured to expect to 'see' a real impedance of 30Ω. However as discussed above, depending on a large number of factors, actual impedance and magnitude of the impedance, presented by the network 114, to the right of dashed line 124 in Figure 1 may vary and cannot be predicted in advance. Therefore, the invention provides an automated method of adjusting the impedance presented by the network 114 to the power source 112 so as to be close to a target impedance, in this example a real impedance of close to 30Ω.

The RF power source may be a substantially conventional NFC driver which applies a drive electrical signal for an antenna 126 of the antenna stage 122 so as to generate an electromagnetic field at the appropriate frequency and modulation and field strength, as set out in the NFC standard.

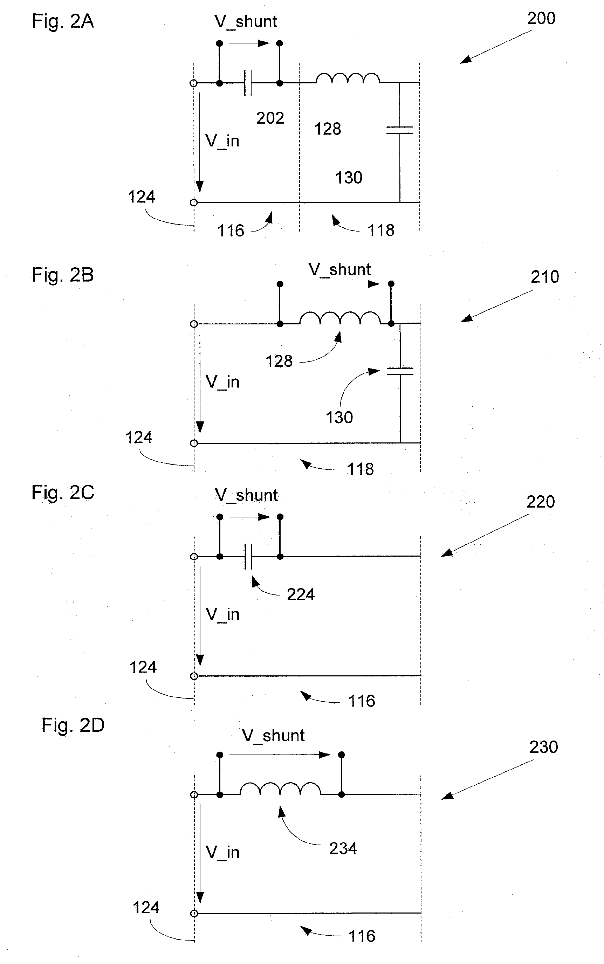

A measurement stage 116, as described in greater detail below with reference to Figures 2A to 2D is provided between the output of the RF power source 112 and the remainder of the network 114. As illustrated schematically in Figure 1, the measurement stage 116 includes one or more electrical components which allows various properties of the current and the voltage in the network 114 to be measured and hence allows the impedance presented by network 114 to the power source 112 to be determined.

Optionally, an EMC filter stage 118 may be provided in network 114. The illustrated EMC filter includes at least a first inductor 128 connected in series and at least a first capacitor 130 connected in parallel and which may be provided to filter overtones of the input signal which in some embodiments may have a rectangular waveform.

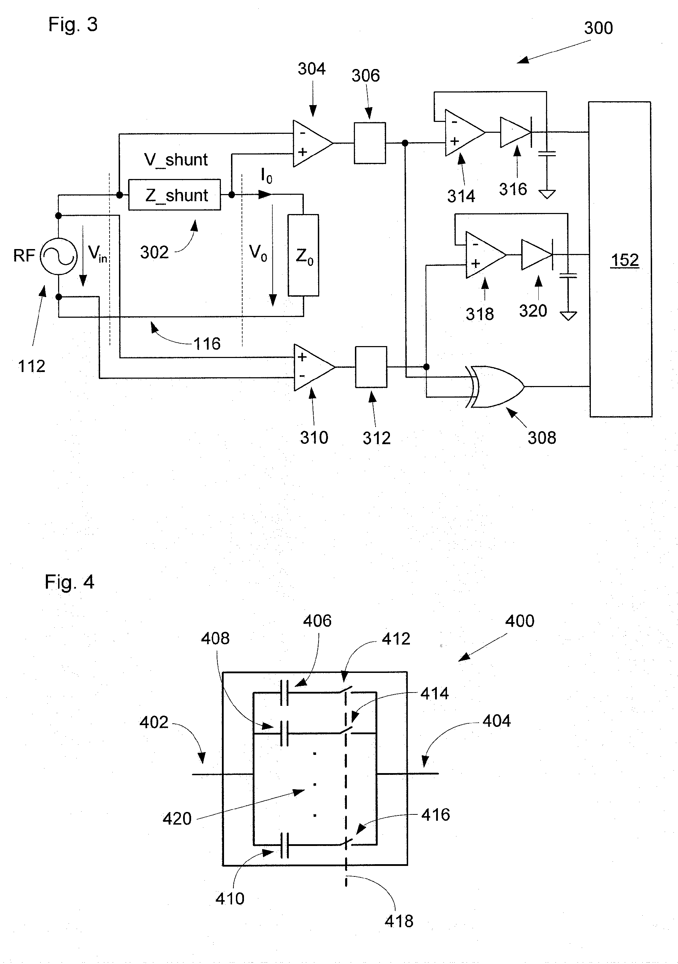

The adjustable impedance stage 120 is intended to adjust the impedance presented by the overall network 114 to more closely match the impedance expected by the power source 112 so as to improve the efficiency of electrical power transfer to the antenna 126. The adjustable impedance stage 120 includes a first adjustable capacitance 132 which is connected in series with the antenna stage 122 and a second adjustable capacitance 134 which is connected in parallel with the antenna stage 122. The series capacitance 132 and the parallel capacitance 134 are each individually adjustable. The capacitance of the series capacitance can vary over the range of from about 3pF to about 100pF with a step size of about 1pF. The capacitance of the parallel capacitance 134 can vary over the range of from about 3pF to about 100pF with a step size of about 1pF. The value of the capacitance in series, Cs, and the value of the capacitance in parallel, Cp, can be automatically adjusted, as described below, so as to better match the impedance presented by the network 114 to that expected by the power source 112 to be real and, for example, about 30Ohm. The construction of the variable capacitances 132, 134 is described in greater detail below with reference to Figure 4.

The antenna stage 122 includes an antenna 126 in the form of an inductor loop antenna comprising a plurality of turns. For example, the antenna can be 35mm x 35mm with 4 turns on ferrite foil. A simplified equivalent circuit representation of such a loop antenna consists of an inductance L_{A} of 1.98 µH and a resistance R_{A} of 0.85 Ohm in series, and a capacitance C_{A} of 2.9 pF in parallel to L_{A} and R_{A}. At the NFC frequency of 13.56MHZ, the impedance Z_{A} of this antenna, approximately 0.926 + j*176.033 Ohm.

However, the construction and operation of NFC antennas is generally known to a person of ordinary skill in the art. Although the antenna may be designed to have a certain impedance at its intended operating frequency, manufacturing variability means that in practice its actual impedance will differ to its intended impedance and also ambient factors can affect the antenna impedance, such as temperature. Further, the NFC interaction is essentially an air-core transformer formed by bringing the loop antenna of the NFC device into close proximity, for example less than 10 cm, with the loop of a second NFC device, or contactless card or RFID tag. The coupling between the two antennae can change the effective impedance of the antenna significantly. Therefore, as the impedance of the antenna may differ to its intended value and may vary during use anyway, the invention provides automatically and adaptively matches the impedance presented by the network 114, and which the antenna 126 terminates, to a target impedance expected by the driving power source 112.

The antenna stage 122 may also include a first resistor 136 connected in series with the antenna 126 and which provides a quality factor damping resistor. The value of the resistance of the resistor 136 is selected to reduce the quality factor of the antenna stage 122 down to a preferred level, for example 25. The Q of the antenna stage is approximately ω x L_{A} / R_{A}, where w is the angular frequency, L_{A} is the inductance of the antenna and R_{A} the resistance of the antenna stage. In selecting the Q of the antenna stage, Q_{A}, there are two competing factors. In order to increase the antenna current for a fixed RF input power the Q_{A} should be increased. However, to transmit data with low time constants, Q_{A} should be decreased. The data transmission specification in the NFC standard sets a limit to the antenna stage Q_{A} of about 25. The complete network 114 determines the operational Q-factor, or system Q-factor. In the case of the antenna being load-matched, then the system Q, Qsys, would be half the value of Q_{A}. In practice there is not load-matching and so the system Q is nearly as high as the antenna Q_{A}. This is to achieve higher efficiency of data transfer, and not for maximum power transmission. Hence, the apparatus is not concerned simply with impedance matching but rather with impedance adjustment to a target impedance which does not necessarily correspond to optimum power transfer.

The digital parts 150 of the system 100 received signals from the analogue part 110 and provides control of the overall operation of the analogue part and individual components thereof, as indicated by various dashed lines in Figure 1. The digital part 150 includes an analogue to digital converter and interface which receives one or more measurement signals from the measurement stage 116. A data processing component 154 receives the digital data output from the ADC interface 152, calculates the current impedance of the network 114 and passes the current impedance of the network 114 to a component 156 which includes impedance adjustment control logic. An impedance adjustment interface 155 receives signals from the impedance adjustment control logic 156 and outputs control signals to the serial adjustable capacitance 132 and/or the parallel adjustable capacitance 134 so as to adjust the overall impedance presented by network 114. The impedance adjustment control logic implements an algorithm to automatically determine impedance values for the series and parallel capacitors so that the impedance presented by network 114 is sufficiently close to the target impedance expected by the driving power source 112 and then outputs control signals to adjust the series and/or parallel capacitances to tune the impedance presented by the network 114 to better match the target impedance. The impedance adjustment algorithm is based on the Newton algorithm for zero-point determination and can be implemented on an FPGA. In other embodiments a suitably programmed general purpose microprocessor can be used or an application specific integrated circuit (ASIC), a digital signal processor or other programmable logic device and or other combinations of hardware and software.

The impedance adjustment control logic 156 is in communication with an overall system controller 158 which in turn may be in communication with a serial interface 160 which provides an interface 162 for other systems or parts of a larger device. The system controller 158 is in communication with a communications protocol component 164 which controls the overall communications protocol used by the system for wireless or contactless communication. A modulation component 166 is in communication with protocol component 164 and controls modulation of the power source to modulate its output signal thereby encoding the data to be transmitted by the antenna 126.

Some or all of the components illustrated in Figure 1 may be provided as a single integrated circuit in a package. For example, in one embodiment, the digital part and the analogue part, other than the antenna 126, may be provided as an integrated circuit in a package and pins of the lead frame may be provided for connecting to a separate antenna.

Figures 2A to 2D show respective schematic circuit diagrams of four embodiments of the measuring stage 116 of the network 114. As explained below, in some embodiments, a separate measurement component is included in the network 114, whereas in other embodiments, a component of the EMC filter may be used to provide the measurement component.

Figure 2A shows a first embodiment 200 of the measurement stage 116 of the network 114. Dashed line 124 represents the interface between the network 114 and the driving power source 112 which supplies an RF drive voltage V_in. As illustrated in Figure 2A, the driving power source 112 applies an input drive signal having a voltage Vin to two input ports of the network 114. The measurement stage 116 includes a first capacitor 202 in series between the output of the driving power source 112 and the remainder of network 114, and in particular the EMC filter stage 118. The first capacitor 202 provides a reactive shunt and is referred to herein as a shunt capacitor. The shunt capacitor 202 has a voltage Vₛₕᵤₙₜ across it which is directly proportional to the input current and with a phase difference of -90° to V_in. The shunt capacitor 202 allows a measurement of the current in the network 114 to be obtained from the shunt voltage as described in greater detail below. Shunt capacitor 202 has a negligibly small parasitic serial resistance and therefore does not lead to significant dissipation in the network 114.

Figure 2B shows a second embodiment 210 of the measurement stage 116 of the network 114. Again, the driving power source 112 applies an input drive signal having a voltage V_in to two input ports of the network 114. In this embodiment, the inductor 128 of the EMC filter is used as part of the measuring stage and is connected in series between the output of the driving power source 112 and the remainder of network 114. The inductor 128 also provides a reactive shunt and may be referred to herein as a shunt inductor. The shunt inductor 128 has a voltage Vₛₕᵤₙₜ across it which is directly proportional to the input current and with a phase difference of +90° to V_in. Again, the shunt inductor 128 allows a measurement of the current in the network 114 to be obtained similarly to shunt capacitor 202. Generally, a shunt inductance 128 will have a greater parasitic resistance than a shunt capacitance 202 and hence greater dissipation. However, if inductor 128 is provided anyway as part of EMC filter 118, then there is no increase in impedance by using it as a shunt reactance as well.

Figure 2C shows a third embodiment 220 of the measurement stage 116 of the network 114. Again, the driving power source 112 applies an input drive signal having a voltage V_in to two input ports of the network 114. In this embodiment, no EMC filter stage is present, as the RF power source outputs a sinusoidal driving voltage, and so no EMC filtering is required. Similarly to Figure 2A, a capacitor 224 is provided in series as a reactive shunt and may be referred to herein as a shunt capacitor. The shunt capacitor 224 has a voltage Vₛₕᵤₙₜ across it which is directly proportional to the input current and with a phase difference of -90° to V_in. The shunt capacitor 224 allows a measurement of the current in the network 114 to be obtained from the shunt voltage as described in greater detail below. Shunt capacitor 224 has a negligibly small parasitic serial resistance and therefore does not lead to significant dissipation in the network 114.

Figure 2D shows a fourth embodiment 230 of the measurement stage 116 of the network 114. Again, the driving power source 112 applies an input drive signal having a voltage V_in to two input ports of the network 114. Also in this embodiment, no EMC filter stage is present, as the RF power source outputs a sinusoidal driving voltage, and so no EMC filtering is required. Similarly to Figure 2B, an inductor 234 is provided in series as a reactive shunt and may be referred to herein as a shunt inductor. The shunt inductor 234 has a voltage Vₛₕᵤₙₜ across it which is directly proportional to the input current and with a phase difference of +90° to V_in. The shunt inductor 234 allows a measurement of the current in the network 114 to be obtained from the shunt voltage. Although shunt inductor 234 may have a greater parasitic resistance than shunt capacitor 224, it may have a much lesser parasitic resistance than the inductance 128 used in the second embodiment 210 (which also provides part of the EMC filter), and therefore does not lead to significant dissipation in the network 114.

The network 114 between the driver part 112 and the antenna 126 is intended to establish a resonant antenna circuit with a resonance at close to the carrier frequency and also to increase the antenna current owing to a reasonably high Q-factor, for example about 20. The network may typically include lumped components such as capacitors, inductors, resistors, and sometimes diodes. As noted above, tolerances in the antenna due to fabrication and due to ambient conditions (e.g. other antennas close by, temperature) and variations in the distance between NFC antennas during an NFC interaction can change the antenna impedance. In order to increase energy efficiency, the impedance presented by the overall network 114 can be varied adaptively responsive to the varying impedance of the antenna. Also, the impedance of the network can be adjusted so that the real impedance of the network 114 is closer to the target impedance which is optimum for the NFC chip driver 112 output. This allows the most efficient power transfer and allows permits a reduction in the headroom in integrated driver power and battery supply, for example by a factor of four, while still providing the same emitted magnetic field strength.

As illustrated in Figure 1, properties of the current and voltage in the network 114 are measured and supplied to the impedance control logic 156 to automatically adjust the impedance of network. Figure 3 shows a schematic block circuit diagram 300 of measurement circuits used to measure the properties of the current and voltage in the network 114. In Figure 3, Z_shunt, 302, represents the shunt inductance of the measurement stage 116, which may be any of those illustrated in Figures 2A to 2D. The current in the network 114 is represented by I₀ and the impedance presented by the network 114 is represented by Z₀. The voltage across the shunt reactance, V_shunt is supplied to the inputs of a first differential amplifier 304 whose output is filtered by a band-pass filter 306 to reduce DC and high-frequency signal components from the intended 13.56MHz carrier frequency. The same principle is used for the shunt voltage, V_shunt, as for the drive voltage, V_in, from the RF power source. The output of the first band-pass filter is supplied to a first input of an exclusive OR gate 308. The voltage across the power source 112, V_in, is supplied to the inputs of a second differential amplifier 310 whose output is filtered by a second band-pass filter 312 to reduce DC and high-frequency signal components from the intended 13.56MHz carrier frequency. The output of the second band-pass filter is supplied to a second input of the exclusive OR gate 308 whose output signal is supplied as a first input to ADC interface 152. The exclusive OR gate 308 and first and second comparators (described below) provide a phase-to-voltage converter. The output signal from the exclusive OR gate 308 has a voltage V_{m_phase} which represents the measured phase difference between V_in and V_shunt. Hence, these components provide a phase measurement circuit which provides as its output a signal indicating the phase difference between V_in and V_shunt which is converted to a digital value by 152 and then passed to data processing component 154 for use by automatic phase adjustment logic 156.

A peak detector circuit is based on a first comparator 314 and a diode 316 which arranged to measure receives the amplitude of the output from the first band-pass filter 306. This circuit provides a low frequency (LF) voltage signal which is proportional to the peak RF current (via the shunt voltage V_shunt). Similarly, a second comparator 318 and diode 320 receives the output from the second band-pass filter 312 at an input and provides a low frequency (LF) voltage signal at its output which is proportional to the peak RF drive voltage, V_in. The measured peak values of V_in (V_{m_in}) and V_{_shunt} (V_{m_shunt}) are supplied to the ADC interface 152 which converts them to digital values and supplies digital data to the data processing block 154. Hence, these components provide a peak voltage measurement circuit which provides as its output signals indicating the peak voltages of V_in and V_shunt.

The impedance of an AC circuit can be expressed generally as **Z** = |**Z**| e^{jϕ} where **Z** is a vector quantity and ϕ is the phase difference between voltage and current. The impedance has real and imaginary components being the resistance, R, and the reactance X. The resistance R = |**Z**| cos ϕ and the reactance X = |**Z**| sin ϕ. The phase difference ϕ is approximately the output of the phase measuring circuit V_{m_phase} and the magnitude of the impedance |**Z**| is approximately the quotient of the outputs of the voltage measuring circuit, V_{m_in}/ V_{m_shunt}. Hence, R and X for the network 114 are calculated by the data processing block 154 and passed to the automatic impedance adjustment circuit 156.

Automatically adjusting the impedance to match a target is a challenge as the system is multiple input, multiple output (MIMO). The multiple inputs are the measured magnitude and phase of the impedance of the network 114 and the multiple outputs are the control signals used to set the values of the serial and parallel capacitances 132, 134. Also there is a non-linear relationship between each of the inputs and the outputs. The automatic impedance adjustment control logic 156 implements a method based on Newton's method for determining the zeroes or stationary points of a function. A method based on Newton's algorithm is used to try and determine values of Cp and Cs which make the impedance presented by the network 114 to the driving power source 112 close to a target value, e.g. 30Ω.

As noted above the impedance of the network 114 is a non-linear function of the capacitance Cs of the serial capacitance 132 and the capacitance Cp of the parallel capacitance 134, i.e., in vector notation, **Z** = *f* (C) in which:

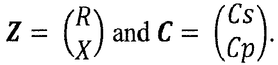

The impedance can be approximately by a linear equation about a working point as **Z ≈ Z₀** + **J (C₀)** ·Δ**C** where **J** is a Jacobi matrix whose elements are the partial differentials of the resistance R and reactance X with respect to Cp and Cs. The objective is solve the linear equation Δ**C** = **J**(**C**₀)⁻¹·(Zₜ - **Z₀)** where **Z₀** is the impedance of the network 114 which is to be matched to the target impedance **Zₜ** expected by the driving power source 112, and which in this example is 30Ω. Hence, the problem is to solve the linear equation to find values of Cp and Cs for which the impedance of the network 114 sufficiently closely matches the target impedance, *i.e*. **Zₜ- Z₀ ≈** 0 and hence corresponding to zero points. An iterative approach is used in which the capacitance of the serial capacitance 132 and the parallel capacitance 134 are alternately and individually adjusted.

Figure 4 shows a schematic bock diagram of a capacitor network 400 with an adjustable capacitance and which can be used to provide the serial adjustable capacitance 132 and the parallel adjustable capacitance 134. The network includes an input 402 and an output 404 for the RF signal and a plurality of individual capacitors, 406, 408, 410 connected in parallel and each having a respective associated electronically operable switch, 412, 414, 416, by which any combination of capacitors can be switched into the RF signal path between the input 402 and output 404. A control signal can be supplied by interface 155 to selectively operate each of switches 412 -416, as indicated by dashed line 418. Although only three capacitor-switch pairs are shown in Figure 4, it will be appreciated that in practice a greater number of capacitor-switch pairs can be provided as indicated by ellipsis 420. The capacitance, C, of capacitor 406 may be 3pF, of capacitor 408 may be 2C, i.e. 6pF, and generally of the Nth capacitor 410 may be 2^{N-1}C. Hence, network 400 generally provides a switched capacitor matrix in which the individual capacitances, C, are binary weighted.

To integrate the adjustable capacitances 132, 134 in silicon, the operating voltages and parasitic elements may be considered. For the parallel capacitance, 134, the voltage across it may be as high as the antenna voltage, which may be, for example, several 10s of volts.

For the capacitance 132 in series with the antenna, the voltage across it can become negative with respect to ground (GND). As a ground connection for an integrated circuit is usually connected to a chip substrate, this would mean negative voltages with respect to the chip substrate. This is not possible for normal CMOS processes. This can be addressed by voltage biasing the serial capacitance 132 so that the average voltage is half of the amplitude value. In this way, the negative amplitude should not be less than 0 V (GND value), but the positive amplitude is twice as high. Another approach is to use an atypical CMOS process called SOI (silicon on isolator) which permits negative voltages.

Parasitic elements mainly concern the switches 412, 414, 416. If switched off, each switch will have a parasitic capacitance. This should be negligibly small compared to the capacitances of the individual capacitances 406, 408, 410 so that the switched-off state maybe considered good. This parasitic switch capacitance would also be voltage-dependent and so could cause additional harmonic emission. If switched on, each switch will normally have its serial resistance, R. This should be negligibly small, so as to allow for adjustment to an appropriate quality factor for the antenna circuit. Otherwise, the Q-factor of the antenna circuit would also depend on the switching state of the antenna matrix 400.

The iterative formula for finding zeros is **Cₙ₊₁** = **Cₙ** + **J(Cₙ)⁻¹·(Zt - Zₙ)** which expresses a value of **C** for a next step (i.e. step n+1) in terms of the values of various elements for a preceding step (i.e. step n). The steps of the iterative method are repeated until a value of **Z** is arrived at which is sufficiently close to the target impedance to be matched **Z₀,** *i.e.* **Zₜ ≈ Z₀.**

A specific function for the input impedance of the network 114 cannot be defined (as it varies depending on manufacturing tolerances, parasitic, ambient effects, the presence of other antennas, etc.) and so a Jacobi matrix cannot be defined as there are no differentiable functions. Instead the partial derivatives of the Jacobi matrix can be approximated by the difference quotients between the current measurement and the preceding measurement. Also, to keep changes in impedance to a minimum at each step, only one of the serial or parallel capacitances is varied at each step. Hence a first approximated Jacobi matrix is used on even steps and another approximated Jacobi matrix is used for odd steps of the method.

For even steps, the approximated Jacobi matrix has the form 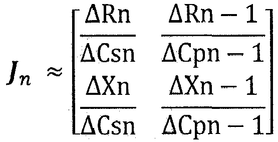 and for odd steps the approximated Jacobi matrix has the form 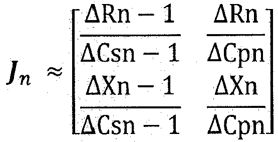 where ΔRₙ= Rₙ - Rₙ₋₁, ΔXₙ= Xₙ - Xₙ₋₁, ΔCₛₙ= Cₛₙ - Cₛₙ₋₁ and ΔCₚₙ= Cₚₙ - Cₚₙ₋₁.

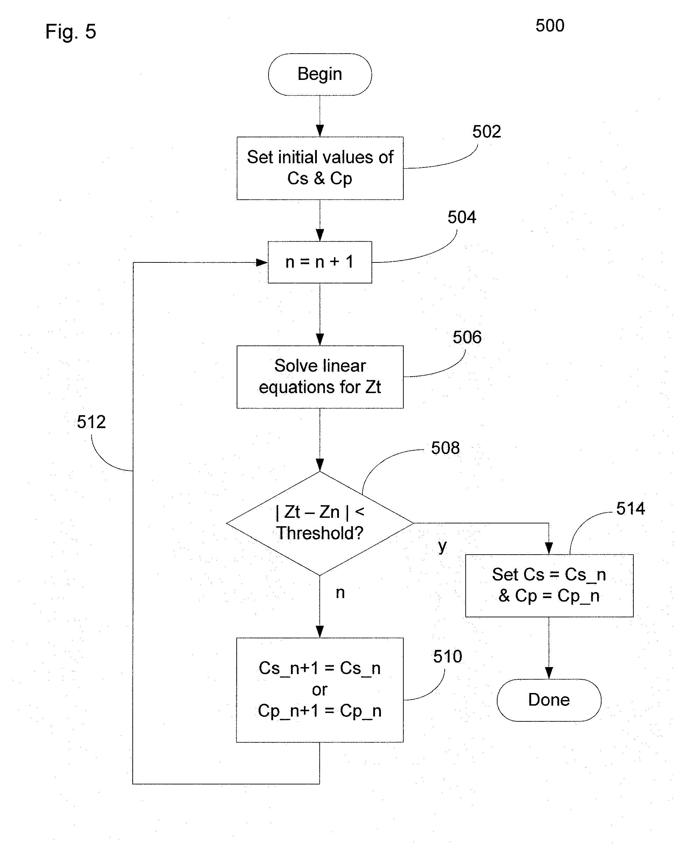

Figure 5 shows a process flow chart illustrating the automatic impedance matching method 500 implemented by automatic impedance adjustment control circuitry 156. The method begins at 502 by setting initial values Cs and Cp for the serial 218 and parallel 220 capacitors. Although the impedance of the network 114 can vary, a typical value may be known in advance and initial values for Cp and Cs can be calculated and selected which will provide approximate matching of the network impedance to the target impedance. At 504 a count n of the current iteration of the method is incremented to reflect a first step, i.e. n = 1. At step 506, the calculated phase ϕ and the magnitude of the impedance Z of the network are obtained from the data processing component 154 and are used to calculate values for X and R for the current and the preceding step of the method. These value are then used to calculate the elements of the appropriate Jacobi above. The linear equation for Δ**C** is solved at step 506 to provide a value for **Zₜ - Zₙ.** As n =1, the value Cp of the parallel capacitance 134 is changed and the step-size and step-direction of the change in Cp is determined by solving the linear equation for Δ**C**. In some embodiments, the magnitude of the step-change may be the minimum possible for the variable impedance capacitors to reduce any transient noise caused by switching to a minimum. In other embodiments, the step change may be greater than the minimum possible so as to converge on a solution more quickly.

At 508 the size of the difference between the target impedance and the network impedance at step n, **Zₙ,** is evaluated to see if the impedance match is sufficiently good for the adjusted value of Cp. For example, this can be done by comparing the magnitude of the difference between them with a threshold value. A suitable value for the threshold can be 3 ohms. If it is determined at step 508 that the impedance match is not sufficiently good yet, then processing proceeds to step 510 at which the value for Cp for the next step, n + 1, which will be step 2 in the current example, is set to the current adjusted value of Cp. Process flow returns, as illustrated by process flow line 512, to step 504 at which the step count is incremented and a second iteration, i.e. n = 2, is begun. As n = 2, the capacitance Cs of the serial capacitance 132 is adjusted and the appropriate Jacobi approximation is used at step 506 to solve for the new value of Cs and using X and R calculated from the phase ϕ and the magnitude of the impedance Z obtained by data processing circuit 154 from newly measured values of V_in and V_shunt. Again, the difference between the target impedance and the newly determined value of Zₙ is compared with the threshold value to see if the impedance match between the network and target impedance is sufficiently good yet. If not, then the value of Cs for the next iteration n=3 is set to the current adjusted value of Cs and then processing returns as described above to step 504 for a third iteration in which the capacitance Cp of the parallel capacitance 134 is adjusted.

Once step 508 determines that a sufficiently good match has been achieved, then processing proceeds to step 514 at which the capacitances of the serial and parallel capacitances are set to the most recent values Csn and Cpn corresponding to the sufficiently good match. Control interface circuit 155 can output one or more control signals over one or more signals paths to adjust the capacitance of the adjustable serial 218 and parallel 220 capacitances during the method 500. If or when the match becomes insufficiently good again, for example because the antenna is no longer proximate another antenna or is brought into proximity with another antenna, then method 500 can be repeated in order to re-adjust the impedances to provide better matching with the target impedance value for the new circumstances.

A benefit of the invention is improved energy efficiency. The invention involves using AC voltage measurement which is simple, accurate and energy-efficient and also measuring the AC current in order to determine the impedance of the network 114. A reactive element, e.g. capacitor 202, is used to measure the AC current via the voltage drop, and using a differential voltage measurement circuit. This means that any power loss otherwise associated with current measurement is avoided.

Furthermore the phase between the driving signal voltage V_in and the current in the network 114 may be measured, in particular, using a circuit having an XOR gate which provides a pulse width modulation signal at the output that is low-pass filtered to a DC voltage related to the desired phase information.

So this approach to impedance adjustment fits well into NFC and wireless power transfer applications as it is power efficient, though simple and accurate.

Further, this approach measures impedance under the frequency and power levels corresponding to operating conditions. This matters, because there are frequency dependent elements in the network and there may be power-dependent elements in the antenna. This prohibits measurement approaches that may also be energy efficient, but which are done using DC voltage and current, or at very low power.

Hence, the invention provides benefits in optimization of energy efficiency in transmission which is applicable for contactless communication and also for wireless charging or contactless power transfer.

The invention may be used in various devices, such as NFC controllers, contactless readers/writers.

## Claims

1. An apparatus for automatically adjusting the impedance of network to match a target impedance, the apparatus comprising:
an electrical power source configured to deliver AC electrical power to a target impedance;
a network having an input for receiving a drive signal from the electrical power source and an output connectable to an antenna, the network including a shunt reactance between the input and the output and at least one variable impedance element;
a phase measuring circuit arranged to measure the phase difference between the voltage of the drive signal and the current of the drive signal in the network using the voltage drop across the shunt reactance;
a voltage measuring circuit arranged to measure the magnitude of the voltage of the drive signal and the magnitude of the voltage drop across the shunt reactance; and
an automatic impedance adjustment circuit in communication with the variable impedance element, the phase measuring circuit and the voltage measuring circuit and arranged to receive the measured phase difference, measured magnitude of the voltage of the drive signal and measured magnitude of the voltage drop across the shunt reactance, to determine the impedance of the network from them and automatically to reduce the difference between the determined impedance of the network and the target impedance by outputting a control signal to adjust the impedance of the variable impedance element.

2. The apparatus as claimed in claim 1, wherein the network includes a first variable impedance element and a second variable impedance element and wherein the automatic impedance adjustment circuit is arranged to output a first control signal to adjust the impedance of the first variable impedance element and a second control signal to adjust the impedance of the second variable impedance element independently of the first variable impedance element.

3. The apparatus as claimed in claim 2, wherein the first variable impedance element is connected in series with the input and the output and the second variable impedance element is connected in parallel with the input and the output.

4. The apparatus as claimed in claim 2 or 3, wherein each variable impedance element is a capacitor network.

5. The apparatus as claimed in claim 4, wherein the capacitor network is an integrated circuit.

6. The apparatus as claimed in any of claims 1 to 5, wherein the shunt reactance is a shunt capacitor.

7. The apparatus as claimed in any of claims 1 to 5, wherein the shunt reactance is a shunt inductor.

8. The apparatus as claimed in any of claims 1 to 8, wherein the network includes an EMC filter.

9. The apparatus as claimed in claim 8, when dependent on claim 7, wherein the shunt inductor also forms part of the EMC filter.

10. The apparatus as claimed in any preceding claim, wherein the automatic impedance adjustment circuit implements an iterative algorithm based on Newton's method to minimise the difference between the impedance of the network and the target impedance.

11. The apparatus as claimed in claim 10, wherein the iterative algorithm adjusts the impedance of a first variable impedance element and a second variable impedance element in turn on alternate iterations.

12. The apparatus as claimed in claim 10 or 11, wherein the iterative algorithm uses an approximation of a Jacobi matrix whose elements include quotients of the differences between a current and a preceding value of the reactance of the network and the capacitance of the variable impedance element and/or the differences between a current and a preceding value of the resistance of the network and the capacitance of the variable impedance element.

13. A semiconductor package comprising a lead frame and an integrated circuit, wherein the integrated circuit comprises the apparatus of any preceding claim.

14. An NFC device including the package of claim 13 and an antenna connected to the output of the network.

15. A method for automatically adjusting the impedance of a network to match a target impedance, the method comprising:
determining the phase difference between the voltage of an AC drive signal applied to an input of a network and the current of the AC drive signal using the voltage drop across a shunt reactance connected in series between an input of the network and an antenna;
determining a first peak magnitude of the voltage of the drive signal and a second peak magnitude of the voltage drop across the shunt reactance; and
iteratively reducing the difference between the impedance of the network, determined using the phase difference and the first and second peak magnitudes, and a target impedance by adjusting the impedance of a variable impedance element in the network.
